Europäisches Patentamt

European Patent Office

Office européen des brevets

(11) Publication number: **0 614 285 A1**

# EUROPEAN PATENT APPLICATION

(21) Application number: **94301008.2**

(22) Date of filing: **11.02.94**

(51) Int. Cl.5: **H03M 1/80**, H03H 19/00

(30) Priority: **02.03.93 US 25265**

(43) Date of publication of application:
**07.09.94 Bulletin 94/36**

(84) Designated Contracting States:
**BE DE DK ES FR GB GR IE IT LU NL PT SE**

(71) Applicant: **ADVANCED MICRO DEVICES, INC.**
**901 Thompson Place**
**P.O. Box 3453**
**Sunnyvale, CA 94088 (US)**

(72) Inventor: **Cabler, Carlin Dru**
**12101 Corner Brook Pass**
**Austin, Texas 78739 (US)**

(74) Representative: **BROOKES & MARTIN**
**High Holborn House**
**52/54 High Holborn**
**London, WC1V 6SE (GB)**

(54) **Digital-to-analog converters.**

(57) A circuit for converting single bit digital input data into analog form includes a reference voltage source, a ground path, a tapped shift register for shifting the single bit digital input data, an operational amplifier having a feedback resistor therearound, and a discrete electronic element connected at one end to the operational amplifier. The circuit also includes structure, responsive to the single bit digital input data as it is being shifted through the shift register, for connected another end of the discrete electronic element to either the reference voltage source or to ground.

FIG. 3

The present invention relates to methods and apparatus for digital signal processing. More Particularly, the present invention relates to digital-to-analog converters and finite impulse response ("FIR") filters.

Digital-to-analog converters ("DAC's") have come to be commonly employed in digital audio applications, such as those involving compact disk ("CD") players, digital audio tape ("DAT") players, and the like. Additionally, DAC's are being incorporated into personal computers ("PC's") to provide them with audio capability. For example, some effort has been expended to include audio capabilities on PC motherboards.

Needless to say, a large dynamic range is a desired characteristic of audio equipment. Those skilled in the digital signal processing art have learned that the greater the number of bits that a DAC can accept with linearity (i.e., in a manner so that the change in the value of one quantity is directly proportional to the change in the value of another quantity), the better the dynamic range of the player or "reproduction equipment" involved.

Conventionally, DAC's derive analog signals from digital data by parallel processing; that is, all or substantial portions of the bits comprising the digital representation of an analog signal sample are used substantially simultaneously to recreate the analog signal sample. A shortcoming and deficiency of this approach is that the more bits employed in a DAC, the harder it is to keep production costs low and the harder it is to maintain desired processing characteristics (e.g., linearity).

To address the foregoing problems and deficiencies, those skilled in the art have developed so-called "oversampling" techniques. By employing these techniques, a DAC using only a very few bits (most often, one bit), at a very high rate, can achieve a performance level equivalent to a DAC having more bits, but operating at a lower rate.

Oversampling apparatus and circuits, in part, convert parallel digital data into a single, high rate, digital bit stream. The portion of oversampling apparatus that perform this conversion are called delta-sigma converters. They are also called "noise-shapers" and "interpolative modulators".

A drawback of conventional delta-sigma converters is the fact that they introduce a significant amount of noise into the conversion process, particularly at higher frequencies. To reduce the amount of noise introduced at lower frequencies, those skilled in the art have heretofore constructed delta-sigma converters in stages. It has been found that the higher the number of stages (or "order" of a given converter), the lower and more random the noise introduced. Those skilled in the art have also developed other techniques for removing unwanted, higher frequency noise. For example, certain passive filters, such as resistor-capacitor filters, have been found to remove high frequency noise components. Likewise, certain active filters, such as resistor-capacitor-operational amplifier filters, have been found to function similarly. Unfortunately, both of these latter two "filter" solutions have proven to need to be very large and complex in order to effect adequate noise removal for general commercial purposes.

Still yet other solutions have recently been proposed to the aforementioned noise problem. A very specific solution is set forth in U.S. Patent 5,012,245 to Scott et al. Scott et al. teach a combination finite impulse response filter and digital-to-analog converter for converting sigma-delta oversampled data into analog form. Scott et al.'s combined filter and converter include a shift register, having a plurality of taps, for shifting the digital input data; a plurality of signal capacitors, corresponding to the taps on the shift register, each signal capacitor having a predetermined capacitance and one end coupled to a summing mode; and a plurality of switching means, corresponding to the plurality of signal capacitors and responding to the corresponding taps on the shift register, for selectively coupling one of two voltage references to the other end of the signal capacitors depending upon the state of the corresponding tap of the shift register and the state of a clock signal. Scott et al. also teach a method of converting single bit digital input data into analog form, characterized by the steps of shifting the digital input data with a multiple tap shift register; summing to a summing mode charge from a plurality of signal capacitors, corresponding to the taps on the shift register, each signal capacitor having a predetermined capacitance; and selectively coupling the capacitors to one of two voltage references depending upon the state of the corresponding tap shift register and the state of a clock signal. Although there are certain advantages to Scott et al.'s solutions, they have several shortcomings relative to the instant invention, which are discussed below.

Notwithstanding development of higher and higher order converters, use of passive filters, use of active filters, the Scott et al. solution described above, and the like, there still remains shortcomings and deficiencies in this art arising from noise introduced and remaining in the signal processing operation. This noise has heretofore been removable only at considerable expense (derived, for example, from involving a greater number of processing steps, a greater number of components, or other such factors), and when the noise has not been fully removed it has generally then been amplified by subsequent linear amplifiers, causing audibly noticeable distortion to arise.

We describe a method that overcomes the shortcomings and deficiencies relating to noise mentioned above by filtering the high frequency noise produced by a sigma-delta digital-to-analog ("D/A") converter without causing any non-linearity to arise.

We also describe an apparatus that effectively and efficiently implements this method.

More specifically, we describe a method for converting single bit digital input data into analog form, which method includes the steps of providing a reference voltage, providing a ground path, shifting a single bit through a tapped shift register to generate values at each tap, summing to a summing node electronic values from a plurality of discrete circuit elements corresponding to the taps on the shift register, and connecting each of the discrete electronic elements to either the reference voltage or to ground based upon the bit values at each tap. In certain embodiments of the method of the present invention, the discrete electronic elements are capacitors. In other certain embodiments of the method of the present invention, the discrete electronic elements are resistors.

We describe a circuit for converting single bit digital input data into analog form, which circuit includes a reference voltage source, a ground path, a shift register having n-taps for shifting the single bit digital input data, an operational amplifier having a feedback resistor therearound, and "n" discrete electronic elements having first ends and second ends. The second ends of the discrete electronic elements are connected to the operational amplifier, and the circuit provided also includes structure, responsive to the single bit digital input data as it is being shifted through the shift register, for connecting the first ends of the discrete electronic elements to the reference voltage source or to the ground path.

Accordingly, our method provides a technique for filtering out the high frequency noise produced by a sigma-delta D/A converter without causing any non-linearity.

Our apparatus uses a relatively simply and inexpensive filter for filtering out the higher frequency noise components of sigma-delta D/A converters.

We also implement a FIR filter with coefficients determined by the ratio of a feedback resistor around an operational amplifier to each of a plurality of resistors.

In the accompanying drawings, by way of example only:

FIG. 1 schematically depicts a prior art technique by which a FIR filter can be employed to remove unwanted noise at high frequencies;

FIG. 2 is a schematic diagram of an embodiment of the present invention employing a plurality of switched capacitors; and

FIG. 3 is a schematic diagram of an embodiment of the present invention employing a plurality of resistors.

As discussed in the description of related art section above, sigma-delta D/A converters are characterized as having relatively low noise at low frequencies and increasingly high noise at higher frequencies. Those skilled in the art recognize that for these types of converters to be useful, some means must exist for filtering out the higher frequency noise components. As also mentioned in the description of related art section above, development of various passive and active filters have not effectively overcome the noise problems.

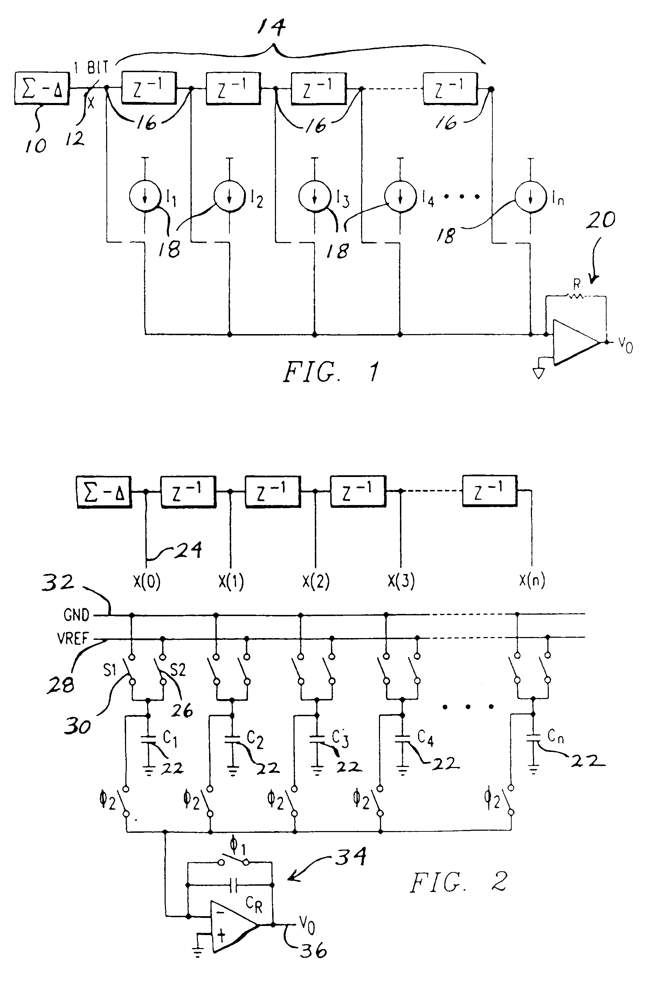

Referring now to the drawings wherein like or similar elements are depicted with identical reference numerals throughout the several views and, more particularly, to FIG. 1, there is shown a relatively new, but yet still prior art technique for filtering the high frequency noise produced by a sigma-delta D/A converter. This technique teaches use of a FIR filter to remove unwanted noise.

More specifically, in FIG. 1 there is shown a sigma-delta converter 10 that produces a single bit output 12. This output 12 is applied to a shift register 14. Each intermediate point 16 of the shift register 14 is tapped and used to control an individual current source 18. The value of each current source essentially comprises the coefficient of the desired FIR filter being implemented as follows: $-1 \times V_0 = RI_1 \, x(o) + RI_2 \, x(1) + RI_3 \, x(2) + \ldots RI_n \, x(n-1)$. That is, the net sum of each of the currents at each sample point in time is converted to a voltage by means of a resistive feedback around an operational amplifier 20. The technique depicted in FIG. 1 of using a combination digital and analog FIR filter greatly reduces the introduction of non-linearities associated with other filtering methods. This is because any errors or mismatches in any of the coefficients causes only a slight error in the frequency response of the filter, rather than a non-linearity.

Referring now to FIG. 2, there is shown a variation on the technique of FIG. 1, except that in FIG. 2 there are a plurality of capacitors 22, rather than current sources 18 (shown in FIG. 1). Further details regarding developments in this direction may be found in U.S. Patent 5,012,245, discussed in the description of related art section above.

Continuing to refer to FIG. 2, the circuit depicted there should be understood to operate as follows: During a first time period, if x(0) 24 is equal to one (1), S2 26 could be connected to VREF 28. If, on the other hand, x(0) 24 is equal to zero (0), S1 30 could be connected to ground 32. Also, during that same time period the capacitor CR 34 could be shorted out. Then, during a second time period, the overall charge in the circuit could be redistributed or "transferred" such that $V_0$ 36 due to the contribution of each capacitor would be $V_0 = -x$ (k) • ($C_R/C_i$). Thus, the total transfer function would be $V_0 = (-C_1/CR)$ • x (0) • ($C_2/CR$) • x (1) - ($C_3/C_R$) • x (2) - ... - ($C_N/C_R$) • x (n-1).

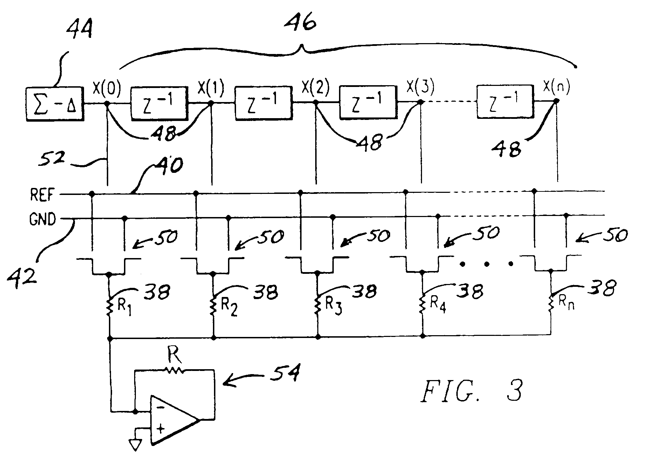

Referring now to FIG. 3, there is shown a D/A FIR filter design for which there is no known precedent of any sort. This design differs from that depicted in FIG. 2 insofar as individual bits are used therein to determine if a given resistor 38 is connected to a reference voltage 40 or to ground 42.

More specifically, the circuit shown in FIG. 3 includes a sigma-delta converter 44 that produces a single bit output. This output is then applied to a shift register 46. Each intermediate point 48 of the shift register 46 is tapped and used to control switches 50 so as to connect a given resistor 38 to either a reference voltage 40 or to ground 42. For example, line 52 controls the left-most switch 50 depicted in FIG. 3 to connect resistor R1 38 to the reference voltage 40 if the bit state at the left-most tab 48 is 1, and line 52 controls the left-most switch 50 in FIG. 3 to connect resistor R1 38 to ground 42 if the state of the bit is 0. All of the various taps and resistors depicted in FIG. 3 operate similarly.

The net result of the foregoing is that an FIR filter is effectively implemented with coefficients determined by the ratio of a feedback resistor around an operational amplifier 54 to each individual resistor 38. More specifically, in this case, the equation created is $V_0 = -REF$ • R [(1/$R_1$) • x (0) + (1/$R_2$) • x (1) + (1/$R_3$) • x (2) + (1/$R_4$) • x (3) + ...(1/$R_N$) • x (n-1). Of course, standard FIR design techniques can be employed to determine the value of each of the coefficients in the equation above.

Based upon the foregoing, those skilled in the art should appreciate that the foregoing invention provides a technique for filtering out high frequency noise produced by a sigma-delta D/A converter without causing any non-linearity. The present invention accomplishes this by providing a relatively simple and inexpensive filter for filtering out the higher frequency noise components of the sigma-delta D/A converter. The embodiment of the present invention depicted in FIG. 3 simply and effectively provides the foregoing by using individual bits shifted through a shift register to determine if a given resistor should be connected to a reference voltage or to ground. Then, an FIR filter is implemented with its coefficients determined by the ratio of a feedback resistor around an operational amplifier to each individual resistor as connected. This embodiment of the present invention is advantageous relative to others described above because resistors can be very easily and inexpensively made in semiconductors. Making resistors involves only conventional processing steps, and less steps than would be required to make capacitors, for instance.

With regard to determining the value of the various coefficients, it may be desirable in embodiments of the present invention to minimize the effect of the switches on the resistance. That is, one would likely want the individual resistors 38, rather than the switches 50, to dominate the resistance compared at the operational amplifier 54. If, for example, resistor R1 was five times larger that resistor R2, it may be desirable to make the switch resistance of the switch associated with R1 five times larger than the switch resistance associated with R2. That way, the ratio remains five to one and one is assured that matching stays as accurate as possible. Other such techniques are well known to those skilled in the art.

Obviously, numerous modifications and variations are possible in view of the teachings above. For example, in FIG. 3 operational amplifier 54 is shown connected to ground. Alternatively, in embodiments of the present invention it could be connected to a half reference voltage source. The reason for this is because that in operation, the circuit depicted in FIG. 3 could operate from an extreme of all switches being off to an extreme of all switches being on. In such a case, the limit of output for the voltage would be from zero to full scale, which would essentially be equivalent to a DC offset of minus full scale over two. Thus, if operational amplifier 54 was connected to half the reference voltage as opposed to ground, the signal would swing in a conventional manner. Another alternative to address the same issue would be to use a blocking capacitor. However, the simplest solution would be to use reference voltage over two source connected to the operational amplifier 54. Additionally, the present invention is taught herein to be formed of capacitors or resistors. A multitude of other alternatives, too many to expressly mention here, are possible. Accordingly, within the scope of the appended claims, the present invention may be practiced otherwise than as specifically described hereinabove.

## Claims

1. A circuit for converting single bit digital input data into analog form, said circuit comprising:
    a reference voltage source;
    a ground path;
    a shift register, having n-taps, for shifting the single bit digital input data;
    an operational amplifier having a feedback resistor therearound;

a discrete electronic element having a first end and a second end, said second end connected to said operational amplifier;

means, responsive to said single bit digital input data as it is being shifted through said shift register, for connecting said first end of said discrete electronic element to said reference voltage source or to said ground path.

2. The circuit as recited in claim 1, wherein there are plurality of discrete electronic elements, each of which is individually associated with a tap of said shift register.

3. The circuit is recited in claim 2, wherein each of said plurality of discrete electronics elements is a resistor.

4. The circuit as recited in claim 2, wherein each of said plurality of discrete electronic elements is a capacitor.

5. The circuit as recited in claim 1, wherein said operational amplifier has an input equal to half of the reference voltage.

6. A method for converting single bit digital input data into analog form, said method comprising the steps of:

providing a reference voltage;

providing a ground path;

shifting a single bit through a tapped shift register to generate values at each tap;

connecting a discrete electronic element to either said reference voltage or to ground based upon the bit value at a tap; and

obtaining the ratio of said connected discrete electronic element to a feedback resistor around an operational amplifier.

7. The method as recited in claim 6, wherein a plurality of discrete electronic elements, each individually associated with a tap on said tapped shift register, are connected to either said reference voltage or to ground based upon the associated tap bit value, and wherein the ratio of all of said connected discrete electronic elements to said feedback resistor around an operational amplifier are obtained.

8. The method as recited in claim 6, wherein said operational amplifier has an input, and further comprising the step of providing a half reference voltage, and still further comprising the step of connecting said input of said operational amplifier to said half reference voltage.

FIG. 1

FIG. 2

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | IBM TECHNICAL DISCLOSURE BULLETIN. vol. 11, no. 7 , December 1968 , NEW YORK US pages 884 - 885 - 'Transversal Filter with Analog Digital Components' * the whole document * | 1-3,6,7 | H03M1/80 H03H19/00 |
| X | IEEE TRANS. CIRCUITS SYST. (USA), IEEE TRANSACTIONS ON CIRCUITS AND SYSTEMS, APRIL 1984, USA, CAS-31, 4, 417 - 419 ISSN 0098-4094 REDDY N S ET AL 'Switched-capacitor realization of FIR filters' * page 418, column 2, line 8 - page 419, column 1, line 4; figure 2 * | 1,2,4,6, 7 | |

|  |  |  | TECHNICAL FIELDS SEARCHED (Int.Cl.5) |
|---|---|---|---|
|  |  |  | H03M H03H |

The present search report has been drawn up for all claims

| Place of search | Date of completion of the search | Examiner |
|---|---|---|
| THE HAGUE | 31 May 1994 | Beindorff, W |

EPO FORM 1503 03.82 (P04C01)